# EUROPEAN PATENT APPLICATION

(11) **EP 4 814 580 A1**
(43) Date of publication of application: **30.09.2026**
(21) Application number: 26163177.4
(22) Date of filing: 09.03.2026
(51) Int. Cl.: G03F 7/00, G03F 7/20, H05B 45/10, H05B 45/20

(54) **ILLUMINATION DEVICE, EXPOSURE APPARATUS, AND ARTICLE MANUFACTURING METHOD**

(30) Priority: 27.03.2025 JP 2025053164
(71) Applicant: Canon Kabushiki Kaisha, Tokyo 146-8501 (JP)
(72) Inventor: TAKADA, Hiroki, Ohta-ku, Tokyo 146-8501 (JP)
(74) Representative: TBK

(57) **Abstract**

The present disclosure includes a wavelength selection element 4 transmitting light of some wavelengths among light from an LED light source 10, a drive unit 23 driving the wavelength selection element 4, a spectrometer 21 acquiring wavelength characteristics of the LED light source 10, and a control unit 22 detecting a change Δλ in a reference wavelength of a center wavelength of the LED light source 10 on the basis of the wavelength characteristics acquired by the spectrometer 21 and causing the drive unit 23 to drive the wavelength selection element 4 such that the center wavelength of the LED light source 10 matches the center wavelength of the wavelengths transmitted by the wavelength selection element 4 on the basis of the change Δλ in the reference wavelength of the center wavelength.

## Description

### BACKGROUND

### TECHNICAL FIELD

The present disclosure relates to an illumination device, an exposure apparatus, an article manufacturing method, and the like.

### BACKGROUND

An exposure apparatus may be used in a lithography process for manufacturing articles such as semiconductor devices. The exposure apparatus includes an illumination device that illuminates a reticle, and a projection optical system projecting a pattern of the illuminated reticle onto a substrate. The substrate has a photoresist on its surface, and when the pattern of the reticle is projected onto the substrate, the pattern is transferred to the photoresist.

As an alternative to mercury lamps used in the exposure apparatuses, replacement with a light emitting diode (LED), which is a solid-state light emitting element, is expected. LED elements are characterized in that they have a broader spectrum during light emission as compared with those of mercury lamps. Therefore, in order to extract only a narrow wavelength range centered on a design wavelength of the projection optical system from a broad spectrum of the LED element, a wavelength selection element is used. Further, light in a wavelength range determined by the wavelength selection element is used as exposure light of the exposure apparatus.

In addition, LED elements have a smaller amount of light emission per element than mercury lamps. Hence, in order to provide sufficient productivity as a light source of an exposure apparatus, it is considered to use, as a light source, an LED array in which a plurality of LED elements are arrayed. When a temperature change occurs in the LED elements due to heat generated by the LED array, a center wavelength (or a peak wavelength) of wavelength characteristics during light emission shifts to a longer wavelength side. In the case of UV-LED elements, this wavelength shift amount may be approximately 1 nm with respect to a temperature change of 20°C to 30°C.

As described above, when LED elements are used in an exposure apparatus, a wavelength selection element is mounted, and the center wavelength of exposure light is set to match the center wavelength of the wavelength selection element. However, when a wavelength shift accompanying a temperature change of the LED elements occurs, a mismatch arises between the center wavelength of the wavelength range extracted by the wavelength selection element and the center wavelength of the LED elements. When the center wavelength of the wavelength selection element does not match the center wavelength of the LED elements, it becomes impossible to extract a wavelength range in which the LED elements provide the maximum light amount, thereby causing a decrease in illuminance of exposure light.

Since a wavelength shift due to a temperature change of the solid-state light source greatly affects the performance of the exposure apparatus, it is generally known to provide a cooling mechanism for suppressing a temperature rise (for example, refer to Japanese Patent Laid-Open No. 2023-96983).

However, even if a cooler is provided in order to suppress a temperature rise in LED elements due to heat, it may not be possible to completely suppress a temperature change of the LED elements.

For example, when LED elements are used in an exposure apparatus, an exposure time can be controlled by switching a power supply of the LED elements ON and OFF. Generally, the exposure time of an exposure apparatus is set to several tens of milliseconds to several hundreds of milliseconds. However, when short-time exposure is performed using LED elements, temperature control by a cooler cannot follow a temperature change of the LED elements, and a temperature change occurs in the LED elements. Therefore, even when a cooler is used, a wavelength shift due to a temperature change of the LED elements may occur, and the above-described performance degradation of the exposure apparatus may be caused.

### SUMMARY

According to an embodiment of the present disclosure, there is provided an illumination device illuminating an irradiation target surface with light from a solid-state light source. The illumination device includes a wavelength selection element allowing light of some wavelengths among light from the solid-state light source to pass therethrough, a drive unit driving the wavelength selection element, a detection unit detecting a value related to a center wavelength of the solid-state light source, and a control unit causing the drive unit to drive the wavelength selection element such that the center wavelength of the solid-state light source matches the center wavelength of the wavelengths passing through the wavelength selection element on the basis of the value related to the center wavelength detected by the detection unit.

Further features of the present disclosure will become apparent from the following description of embodiments with reference to the attached drawings.

### BRIEF DESCRIPTION OF THE DRAWINGS

Fig. 1 is a schematic view showing an example of a configuration of an exposure apparatus according to First Embodiment.
Fig. 2A is a diagram showing an example of wavelength characteristics when light from LED elements passes through a wavelength selection element.
Fig. 2B is a diagram showing another example of wavelength characteristics when light from the LED elements passes through the wavelength selection element.
Fig. 3 is a conceptual view when the wavelength selection element is tilted with respect to an optical axis.
Fig. 4A is a diagram showing an example of changes in wavelength characteristics when the wavelength selection element is tilted with respect to the optical axis.
Fig. 4B is a diagram showing another example of change in wavelength characteristics when the wavelength selection element is tilted with respect to the optical axis.
Fig. 5 is a flowchart showing an example of an operation for matching center wavelengths of an LED light source and the wavelength selection element according to First Embodiment.
Fig. 6 is a schematic view showing a configuration of an exposure apparatus according to Second Embodiment.
Fig. 7 is a flowchart showing an example of an operation for matching the center wavelengths of the LED light source and the wavelength selection element according to Second Embodiment.
Fig. 8 is a schematic view showing an example of a configuration of an exposure apparatus according to Third Embodiment.
Fig. 9 is a flowchart showing an example of an operation for matching the center wavelengths of the LED light source and the wavelength selection element according to Third Embodiment.

### DESCRIPTION OF THE EMBODIMENTS

Hereinafter, with reference to the accompanying drawings, favorable modes of the disclosure will be described using Embodiments. In each diagram, the same reference signs are applied to the same members or elements, and duplicate description will be omitted or simplified.

### [First Embodiment]

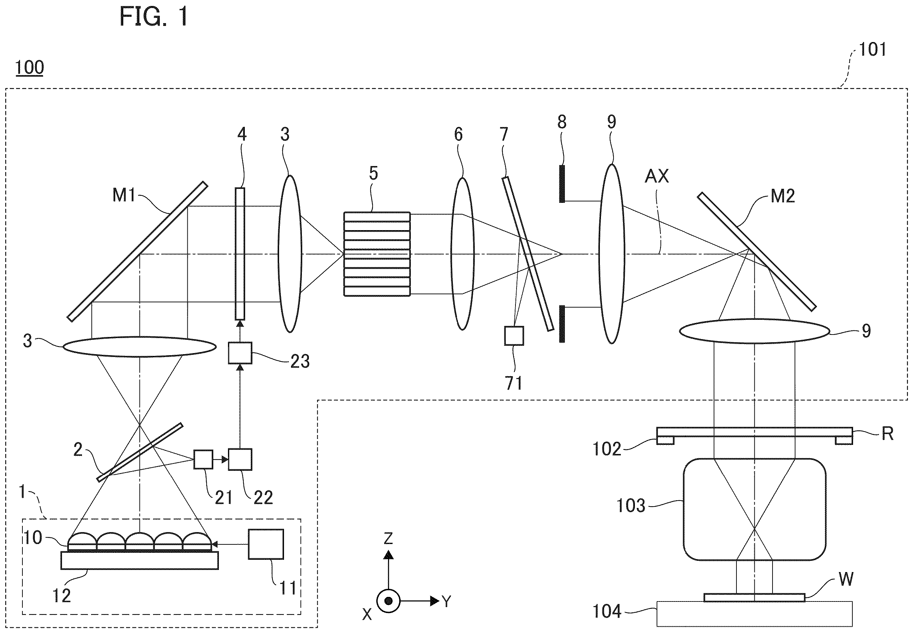

Fig. 1 is a schematic view showing a configuration of an exposure apparatus 100 according to First Embodiment of the disclosure. For example, the exposure apparatus 100 is a lithography device used in a manufacturing process (lithography process) of semiconductor devices and the like, in which a pattern is formed on a substrate. The exposure apparatus 100 exposes a substrate W with a reticle R therebetween. In Embodiment, the exposure apparatus 100 is a step-and-repeat-type exposure apparatus (stepper) collectively exposing the substrate W with the reticle R therebetween. However, the exposure apparatus 100 can also employ a step-and-scan method or other exposure methods.

As shown in Fig. 1, the exposure apparatus 100 has an illumination device 101, a reticle drive unit 102, a projection optical system 103, and a substrate drive unit 104. In addition, in Embodiment, a coordinate system is defined in which an axis extending in a normal direction of the substrate W is set as a Z axis and, axes extending in directions orthogonal to each other within a plane parallel to the substrate W are set as an X axis and a Y axis.

The illumination device 101 illuminates the reticle R disposed on an illumination target surface (object surface of the projection optical system 103) using light (light flux) from a light source unit 1.

A pattern (for example, a circuit pattern) to be transferred to the substrate W is formed on the reticle R. The reticle R is constituted of a material transmitting light from the light source unit 1, for example, quartz glass, which serves as a base material. For example, the reticle drive unit 102 includes a movable reticle stage for holding the reticle R, and a reticle drive mechanism for driving the reticle stage with respect to the X axis and the Y axis.

The projection optical system 103 projects the pattern of the reticle R illuminated by the illumination device 101 onto the substrate W. The projection optical system 103 includes an imaging optical system in which a front focal point thereof is disposed on a surface (position) where the reticle R is disposed, and a rear focal point thereof is disposed on a surface where the substrate W is disposed. In other words, the projection optical system 103 sets the disposition position of the reticle R and the disposition position of the substrate W in a conjugate relationship.

The substrate W is a substrate onto which the pattern of the reticle R is transferred, and has a resist (photosensitive material) on its surface. The substrate drive unit 104 includes a movable substrate stage for holding the substrate W, and a substrate drive mechanism for driving a substrate stage with respect to the X axis, the Y axis, and the Z axis (as well as rotational directions ωx, ωy, and ωz thereof).

Hereinafter, the illumination device 101 will be described in detail. The illumination device 101 includes the light source unit 1, a wavelength measurement extraction mirror 2, a first relay lens 3, a folding mirror M1, and a wavelength selection element 4. The illumination device 101 further includes an optical integrator 5, a second condenser lens 6, an illuminance measurement extraction mirror 7, a field stop 8, an imaging lens 9, and a folding mirror M2.

For example, the light source unit 1 includes an LED light source 10 including an LED array in which a plurality of LED elements (solid-state light emitting elements) are arranged. The LED light source 10 emits light having an output corresponding to the input power from a power supply unit 11, and also performs power supply ON/OFF control.

The LED elements require a short time from when a current begins to flow through a substrate circuit that controls light emission until light output becomes stable, and unlike mercury lamps utilized in exposure apparatuses in the related art, do not need to emit light at all times, thereby providing advantages in terms of energy saving and long lifetime. In addition, in order to provide sufficient productivity as a light source of the exposure apparatus, the light source unit 1 is configured to have an LED array in which a plurality of LED elements are arrayed. Even when LED elements are arrayed, in order to further enhance the productivity, in one embodiment, power supplied to the LEDs and enhance light output are increased. However, as the degree of integration of the LED array becomes higher, and as the supplied power becomes larger, the total amount of heat generated from the LED array light source increases.

A cooler 12 is attached to the LED light source 10, and controls long-term temperature changes of the LED elements. For example, the cooler 12 is a liquid-cooled heat sink. The cooler 12 can circulate a refrigerant within the cooler by a refrigerant pump (not shown), dissipate heat transferred from the LEDs, and cool the LED elements. Parameters related to cooling (cooling conditions) include a refrigerant flow rate and a refrigerant temperature. As the refrigerant flow rate is increased, and as the refrigerant temperature is lowered, cooling performance is improved so that a larger amount of heat can be removed from the LED elements by cooling. However, the refrigerant temperature is generally set around an environmental temperature (room temperature) of the light source.

The wavelength measurement extraction mirror 2 is disposed between the light source unit 1 and the first relay lens 3, extracts a part of light from the light source unit 1, and guides the extracted light to a spectrometer 21. The spectrometer 21 measures wavelength characteristics of the light emitted from the light source unit 1. Measurement results of the spectrometer 21 are provided to a control unit 22. That is, the spectrometer 21 functions as a wavelength measurement unit measuring wavelength characteristics of the solid-state light source.

The first relay lens 3 includes an imaging optical system and guides light emitted from the light source unit 1 to the optical integrator 5. In Embodiment, an imaging optical system is shown, but an optical system not having such a relationship may be included.

In one embodiment, the wavelength selection element 4 transmitting only light in a particular wavelength range is disposed in the vicinity of a pupil plane of the first relay lens 3. As described above, the LED elements have a broader spectrum during light emission as compared with those of mercury lamps. When a light source having a broad spectrum is used, the projection optical system 103 causes chromatic aberration, thereby degrading image performance. Hence, the wavelength selection element 4 is used in order to extract only a narrow wavelength range centered on a design wavelength of the projection optical system 103 from the broad spectrum of the LED elements. Generally, the wavelength selection element 4 used in an exposure apparatus is an optical filter having a transmittance only in a designated wavelength range.

An exposure wavelength (wavelength of exposure light for the substrate W) is defined by the wavelength selection element 4. Light in the wavelength range determined (selected) by the wavelength selection element 4 is used as exposure light of the exposure apparatus 100. The wavelength selection element 4 is not limited to one kind, and two or more kinds may be adopted. The wavelength selection element 4 is provided with a drive unit 23, and the drive unit 23 is controlled by the control unit 22. That is, the wavelength selection element 4 allows light of some wavelengths among light from the solid-state light source to pass (be transmitted) therethrough.

The drive unit 23 can tilt (drive) the wavelength selection element 4 with respect to an optical axis AX about the X axis or the Y axis as a rotation center. In Embodiment, a drive method performed by tilting the wavelength selection element 4 will be described. However, a method may also be adopted in which a wavelength selection element having a transmittance distribution, in which the transmission wavelength varies within a plane, is prepared and the wavelength selection element is shifted along the X axis or the Y axis.

For example, the optical integrator 5 is a fly-eye lens, and is an element forming a plurality of secondary light sources by two-dimensionally arraying a plurality of microlenses in alignment with a light incidence direction. An incidence surface of each microlens of the optical integrator 5 has a conjugate relationship with an irradiation target surface. Examples of the fly-eye lens include a cylindrical lens and a microlens array, but an optical rod or a diffractive optical element may be adopted.

The second condenser lens 6 superposes and illuminates light emitted from each microlens of the optical integrator 5 onto the field stop 8. The field stop 8 includes a plurality of movable light shielding plates forming an arbitrary aperture shape, and limits an exposure range at the disposition position of the reticle (and further, the disposition position of the substrate) which is an irradiation target surface. The imaging lens 9 forms an image of the field stop 8 on the reticle R in a conjugate relationship, thereby illuminating the reticle R with an aperture shape defined by the field stop 8.

The illuminance measurement extraction mirror 7 can reflect a part of light illuminating the field stop 8, and an illuminance meter 71 is disposed at an imaging position of light reflected by the illuminance measurement extraction mirror 7. The imaging position where the illuminance meter 71 is positioned is equivalent to the position of the field stop 8, which is an imaging position of the second condenser lens 6. In addition, since the field stop 8 is conjugated with the reticle R, the illuminance meter 71 is equivalent to observation of the illuminance on the reticle R (irradiation target surface).

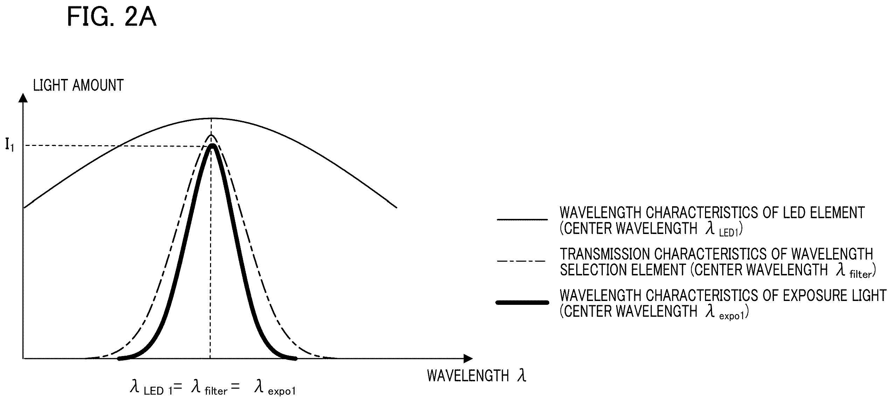

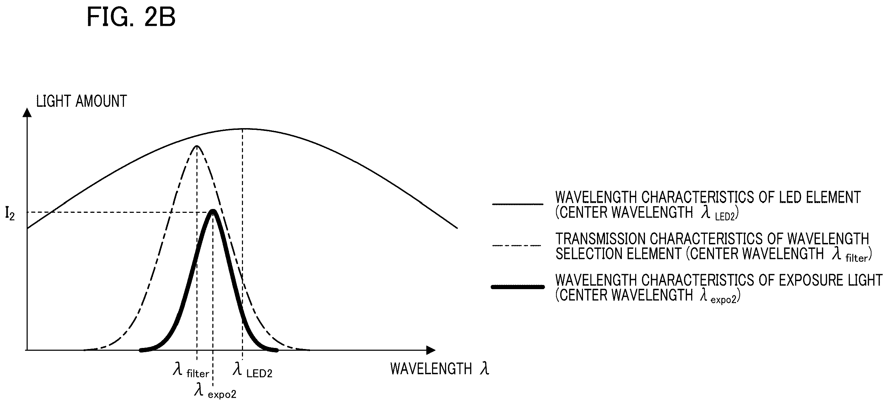

With reference to Figs. 2A and 2B, wavelength characteristics of exposure light will be described. Fig. 2A shows wavelength characteristics of the LED light source 10 when no wavelength shift due to a temperature change of the LED light source 10 has occurred, transmission characteristics of the wavelength selection element 4, and wavelength characteristics of exposure light. Since no wavelength shift has occurred, a center wavelength λ_{LED1} of the wavelength characteristics of the LED light source 10 matches a center wavelength λ_{filter} of the transmission characteristics of the wavelength selection element 4. Therefore, a center wavelength λₑₓₚₒₗ of the wavelength characteristics of exposure light, which is obtained by superimposing the wavelength characteristics of the LED light source 10 and the transmission characteristics of the wavelength selection element 4, does not change. In addition, the amount of exposure light at this time is referred to as I₁.

Fig. 2B shows the wavelength characteristics of the LED light source 10 when a wavelength shift due to a temperature change of the LED light source 10 has occurred, the transmission characteristics of the wavelength selection element 4, and the wavelength characteristics of exposure light. Since a wavelength shift due to a temperature change of the LED light source 10 has occurred, a center wavelength λ_{LED2} of the wavelength characteristics of the LED light source 10 moves to a longer wavelength side than the center wavelength λ_{filter} of the transmission characteristics of the wavelength selection element 4. Therefore, a center wavelength λₑₓₚₒ₂ of the wavelength characteristics of exposure light, which is obtained by superimposing the wavelength characteristics of the LED light source 10 and the transmission characteristics of the wavelength selection element 4, does not match the center wavelength λ_{filter} of the transmission characteristics of the wavelength selection element 4.

With respect to the center wavelength λₑₓₚₒ₂ of the wavelength characteristics of exposure light when a wavelength shift has occurred, a wavelength error Δλₑᵣᵣₒᵣ=λₑₓₚₒₗ-λₑₓₚₒ₂ occurs as compared with a case where no wavelength shift has occurred. The wavelength error Δλₑᵣᵣₒᵣ causes chromatic aberration in the projection optical system 103, which may degrade image performance. In addition, an amount of exposure light I₂ when a wavelength shift has occurred becomes smaller by ΔI=I₂-I₁ as compared with a case where no wavelength shift has occurred. A decrease in light amount causes a decrease in productivity of the apparatus.

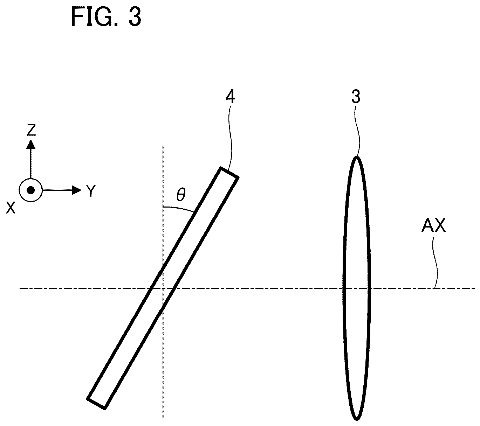

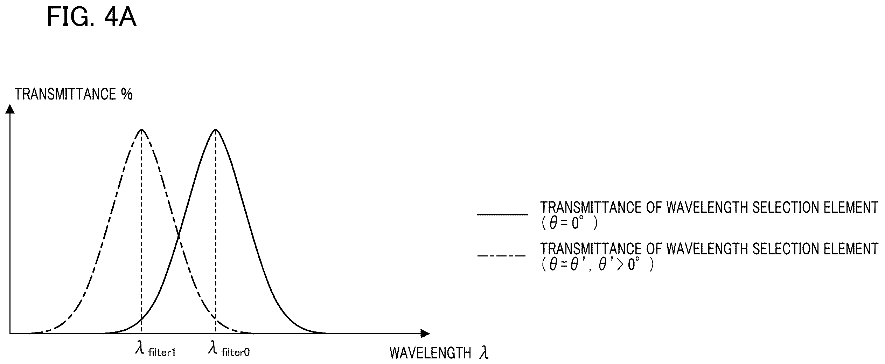

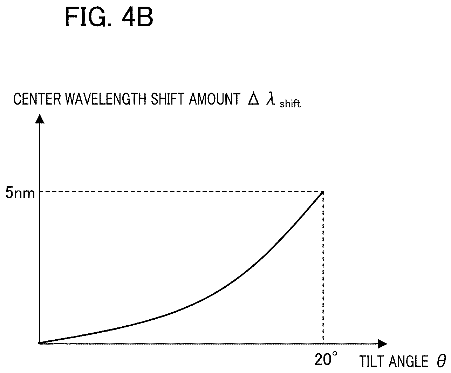

Next, with reference to Figs. 3, 4A, and 4B, a method for changing the transmission characteristics of the wavelength selection element 4 will be described. Fig. 3 is an enlarged view of an area around the wavelength selection element 4 in Fig. 1. The wavelength selection element 4 can be tilted with respect to the optical axis AX about the X axis or the Z axis by the drive unit 23. An angle by which the wavelength selection element 4 is tilted with respect to the X axis or the Z axis is referred to as a tilt angle θ.

Fig. 4A shows changes in wavelength characteristics when the wavelength selection element 4 is tilted with respect to the optical axis. When the tilt angle θ=0°, the center wavelength of the wavelength selection element 4 is λ_{filter0}, whereas when tilted to a tilt angle θ=θ' (θ'>0°), the wavelength characteristics are shifted, and the center wavelength of the wavelength selection element 4 changes to λ_{filter1}. By tilting the wavelength selection element 4, an optical path length of light passing through the wavelength selection element 4 changes, thereby causing a shift of the wavelength characteristics. Therefore, the center wavelength shift amount changes by Δ_{shift}=λ_{filter1}-λ_{filter0} depending on a tilt angle θ'.

Fig. 4B shows an example of a relationship between the tilt angle θ and the center wavelength shift amount Δλ_{shift}. When the tilt angle θ is increased, the center wavelength shift amount Δλ_{shift} can be increased. As an example, the center wavelength shift amount Δλ_{shift} of approximately 5 nm can be generated by tilting the wavelength selection element 4 by approximately 20°.

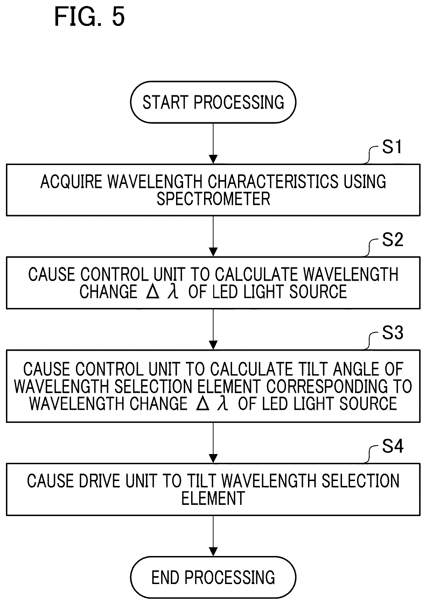

Next, with reference to Fig. 5, a flowchart of an operation for matching the center wavelengths of the LED light source 10 and the wavelength selection element 4 according to Embodiment will be described. For example, the flowchart of Fig. 5 is executed by the control unit 22. In Fig. 5, each process (step) is denoted by adding the prefix "S" to the beginning thereof, thereby omitting the description "process (step)".

First, in S1, the control unit 22 acquires the wavelength characteristics of the LED light source 10 using the spectrometer 21. At this time, the center wavelength of the wavelength characteristics is referred to as λ_{LED1}.

Next, in S2, on the basis of results of the wavelength characteristics acquired by the spectrometer 21, the control unit 22 calculates a change (center wavelength change) Δλ of the center wavelength of the LED light source 10 with respect to a reference wavelength. The reference wavelength may be a center wavelength λ_{LED0} when lighting of the LED light source 10 is started, or may be a wavelength λ_{target} set in advance as a target value. The center wavelength change Δλ of the LED light source 10 is expressed as Δλ=λ_{LED1}-λ_{LED0}, or λ=λ_{LED1}-λ_{target}.

That is, in Embodiment, the center wavelength change Δλ of the LED light source 10 corresponds to a value related to the center wavelength of the solid-state light source. Therefore, the spectrometer 21 and the control unit 22 function as detection units.

Next, in S3, the control unit 22 calculates a tilt angle Δθ of the wavelength selection element 4 corresponding to the center wavelength change Δλ calculated in S2. As shown in Fig. 4, a relationship between the tilt angle Δθ of the wavelength selection element 4 and the center wavelength shift amount Δλ_{shift} is measured in advance and stored in the control unit 22. That is, the control unit 22 stores a correspondence relationship between the center wavelength of the wavelengths passing through the wavelength selection element and a drive amount of the wavelength selection element.

Further, using the relationship between the center wavelength shift amount Δλ_{shift} and the tilt angle Δθ of the wavelength selection element 4 measured in advance, the tilt angle Δθ of the wavelength selection element 4 matching the center wavelength change Δλ of the LED light source 10 calculated in S2 is guided. That is, the control unit 22 calculates the drive amount of the wavelength selection element in accordance with the center wavelength of the wavelength characteristics measured by the wavelength measurement unit.

Next, in S4, the control unit 22 provides information on the tilt angle Δθ of the wavelength selection element 4 calculated in S3 to the drive unit 23, and the drive unit 23 tilts the wavelength selection element 4 by the tilt angle Δθ. By tilting the wavelength selection element 4 by the tilt angle Δθ, the center wavelengths of the LED light source 10 the wavelength selection element 4 can be matched. That is, on the basis of the value related to the center wavelength detected by the detection unit, the control unit 22 causes the drive unit to drive the wavelength selection element such that the center wavelength of the solid-state light source matches the center wavelength of the wavelengths passing through the wavelength selection element.

According to this flowchart, by constantly monitoring the wavelength characteristics of the LED light source 10 using the spectrometer 21 after lighting of the LED light source 10, the center wavelength of the LED light source 10 can always match the center wavelength of the wavelength selection element 4.

In the flowchart of Fig. 5, the tilt angle Δθ is calculated from the center wavelength change Δλ. However, a method may also be employed in which a relationship between the center wavelength of the wavelength characteristics acquired in S1 and the tilt angle of the wavelength selection element is measured in advance and stored in the control unit 22. That is, the tilt angle of the wavelength selection element 4 may be calculated on the basis of an absolute value instead of a change amount.

### [Second Embodiment]

Next, an illumination device according to Second Embodiment will be described. Descriptions of configurations identical to those of First Embodiment will be omitted, and the following description will focus mainly on differences from First Embodiment.

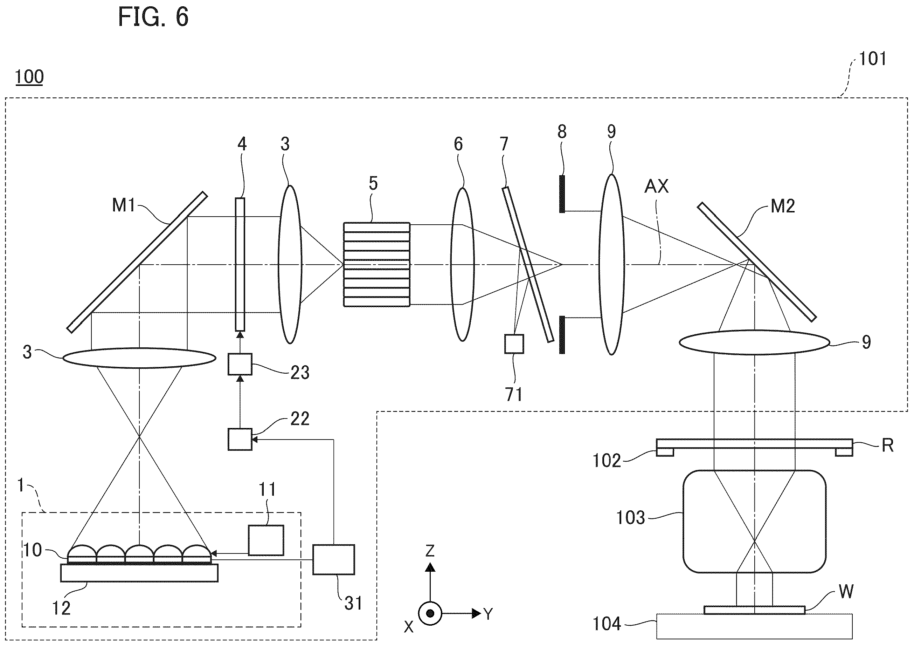

Fig. 6 shows a configuration of an exposure apparatus according to Second Embodiment. Differences from Fig. 1 described in First Embodiment include that the wavelength measurement extraction mirror 2 and the spectrometer 21 are omitted, and a thermometer 31 for measuring the temperature of the LED light source 10 is added. As described above, since the center wavelength change Δλ of the LED light source 10 is caused by the temperature change of the LED light source 10, the center wavelength change Δλ of the LED light source 10 can be detected by monitoring a temperature change ΔT of the LED light source 10. That is, the thermometer 31 functions as a temperature measurement unit measuring the temperature of the solid-state light source.

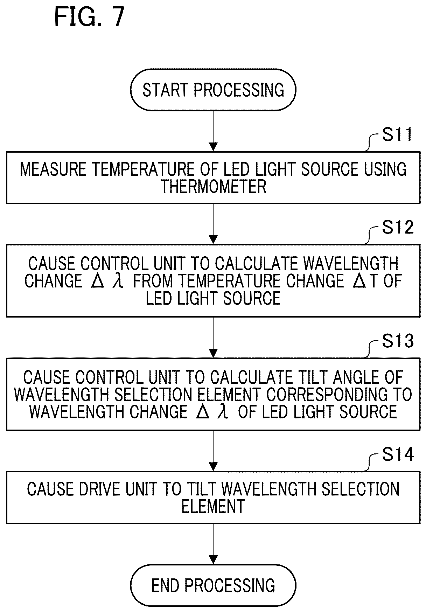

Fig. 7 is a flowchart of an operation for matching the center wavelengths of the LED light source 10 and the wavelength selection element 4 according to Second Embodiment. Similarly to Fig. 5, the flowchart of Fig. 7 is also executed by the control unit 22, for example.

First, in S11, the control unit 22 measures the temperature change of the LED light source 10 using the thermometer 31. The temperature at the time of lighting is set as an initial temperature T0, and the temperature change (amount) ΔT=T1-T0 is measured (detected) when the temperature changes to a temperature T1 at the time of measurement.

Next, in S12, the control unit 22 calculates the center wavelength change Δλ of the wavelength characteristics of the LED light source 10 from the temperature change ΔT of the LED light source 10. Since the center wavelength of the LED light source 10 changes when a temperature change occurs, the relationship between the temperature change ΔT of the LED light source 10 and the center wavelength change Δλ is acquired in advance and stored in the control unit 22. Therefore, the center wavelength change Δλ of the LED element can be guided from the results of the temperature change ΔT measured in S11.

That is, the temperature change ΔT of the LED light source 10 is a value related to the center wavelength change Δλ of the LED light source 10. Therefore, in Embodiment, the temperature change ΔT of the LED light source 10 corresponds to the value related to the center wavelength of the solid-state light source. Therefore, the thermometer 31 and the control unit 22 function as detection units.

Next, in S13, the control unit 22 calculates the tilt angle Δθ of the wavelength selection element 4 corresponding to the center wavelength change Δλ calculated in S12. In this step, similar to S3 in Fig. 5, as shown in Fig. 4, the relationship between the tilt angle Δθ of the wavelength selection element 4 and the center wavelength shift amount Δλ_{shift} is measured in advance and stored in the control unit 22. Using the relationship between the center wavelength shift amount Δλ_{shift} and the tilt angle of the wavelength selection element 4 measured in advance, the tilt angle Δθ of the wavelength selection element 4 matching the center wavelength change Δλ of the LED light source 10 calculated in S12 is guided. That is, the control unit 22 calculates the drive amount of the wavelength selection element in accordance with the temperature measured by the temperature measurement unit.

Further, in S14, similar to S4 in Fig. 5, the control unit 22 provides information on the tilt angle Δθ of the wavelength selection element 4 calculated in S13 to the drive unit 23, and the drive unit 23 tilts the wavelength selection element 4 by the tilt angle Δθ. By tilting the wavelength selection element 4 by the tilt angle Δθ, the center wavelengths of the LED light source 10 the wavelength selection element 4 can be matched.

According to the flowchart of Fig. 7, the control unit 22 calculates the value related to the center wavelength of the solid-state light source in accordance with the temperature measured by the temperature measurement unit and calculates the drive amount of the wavelength selection element in accordance with the calculated center wavelength of the solid-state light source.

According to this flowchart, by constantly monitoring the temperature change of the LED light source 10 using the thermometer 31 after lighting of the LED light source 10, the center wavelength of the LED light source 10 can always match the center wavelength of the wavelength selection element 4.

In the flowchart of Fig. 7, calculation is performed in two steps, such as calculation of the center wavelength change Δλ from the temperature change ΔT of the LED light source 10 performed in S12, and calculation of the tilt angle θ of the wavelength selection element 4 from the center wavelength change Δλ performed in S13. However, since both the center wavelength change Δλ and the tilt angle θ of the wavelength selection element 4 are results of prior measurement, the tilt angle θ of the wavelength selection element 4 may be directly calculated from the temperature change ΔT of the LED light source 10, and S12 and S13 may be combined.

In addition, in the flowchart of Fig. 7, the tilt angle Δθ is calculated from the temperature change ΔT via the center wavelength change Δλ. However, a method may also be adopted in which a temperature is acquired in S11 instead of a temperature change, and a relationship between the acquired temperature and the tilt angle of the wavelength selection element is measured in advance and stored in the control unit 22. That is, the tilt angle of the wavelength selection element 4 may be calculated on the basis of an absolute value instead of a change amount.

### [Third Embodiment]

Next, an illumination device according to Third Embodiment will be described. Descriptions of configurations identical to those of First and Second Embodiments will be omitted, and the following description will focus mainly on differences from First and Second Embodiments.

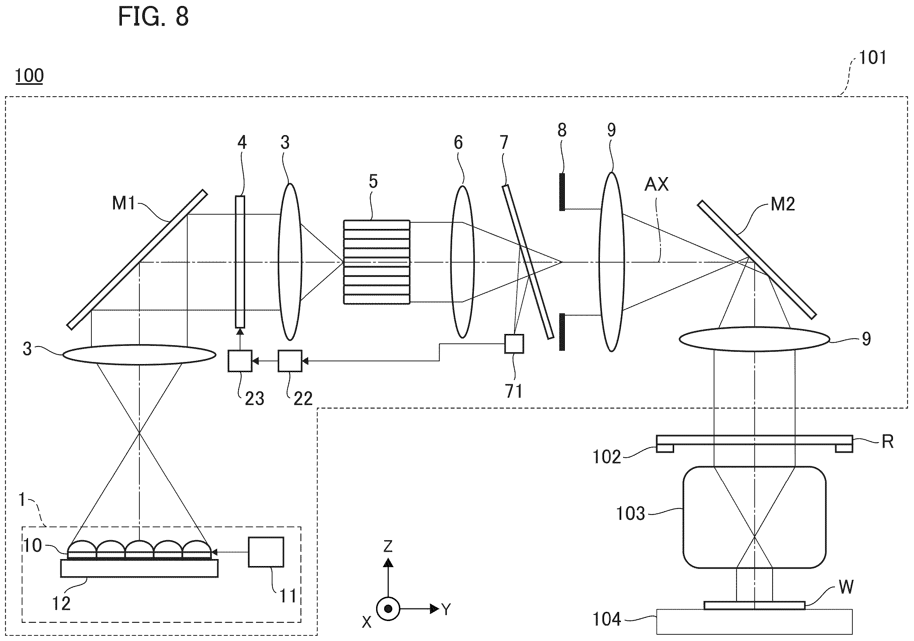

Fig. 8 shows a configuration of an exposure apparatus according to Third Embodiment. Differences from Fig. 1 described in First Embodiment include that the wavelength measurement extraction mirror 2 and the spectrometer 21 are omitted, and the illuminance meter 71 and the control unit 22 are connected. As described above, when a center wavelength shift due to a temperature change of the LED light source 10 occurs and the center wavelengths of the LED light source 10 do not match the wavelength selection element 4, an illuminance decrease occurs. Therefore, by monitoring the illuminance change using the illuminance meter 71, a center wavelength shift of the LED elements can be estimated. That is, the illuminance meter 71 functions as an illuminance measurement unit measuring the illuminance of the solid-state light source.

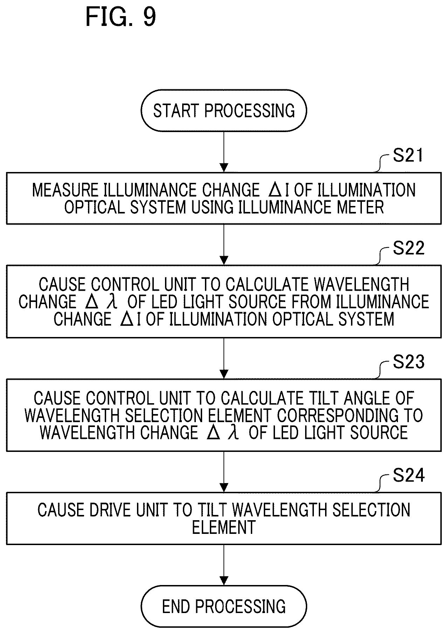

Fig. 9 is a flowchart of an operation for matching the center wavelengths of the LED light source 10 and the wavelength selection element 4 according to Third Embodiment. Similarly to Fig. 5, the flowchart of Fig. 9 is also executed by the control unit 22, for example.

First, in S21, the control unit 22 measures the illuminance change of the illumination device 101 using the illuminance meter 71. The illuminance at the time of lighting of the LED light source 10 is set as an initial illuminance I0, and the illuminance change ΔI=I1-I0 is measured (detected) when the illuminance changes to an illuminance I1 at the time of measurement.

Next, in S22, the control unit 22 calculates the center wavelength change Δλ of the wavelength characteristics of the LED light source 10 from the illuminance change ΔI of the illumination device 101. When a center wavelength shift due to a temperature change of the LED light source 10 occurs, an error arises with respect to the center wavelength of the wavelength selection element 4, thereby causing an illuminance decrease. Thus, a relationship between the center wavelength change Δλ of the LED light source 10 and the illuminance change ΔI is acquired in advance and stored in the control unit 22. Therefore, the center wavelength change Δλ of the LED light source 10 can be guided from the results of the illuminance change ΔI measured in S21.

That is, the illuminance change ΔI of the illumination device 101 is a value related to the center wavelength change Δλ of the LED light source 10. Therefore, in Embodiment, the illuminance change ΔI of the illumination device 101 corresponds to the value related to the center wavelength of the solid-state light source. Therefore, the illuminance meter 71 and the control unit 22 function as detection units.

Next, in S23, the control unit 22 calculates the tilt angle Δθ of the wavelength selection element 4 corresponding to the center wavelength change Δλ calculated in S22. In this step, similar to S3 in Fig. 5, as shown in Fig. 4, the relationship between the tilt angle Δθ of the wavelength selection element 4 and the center wavelength shift amount Δλ_{shift} is measured in advance and stored in the control unit 22. Using the relationship between the center wavelength shift amount Δλ_{shift} and the tilt angle of the wavelength selection element 4 measured in advance, the tilt angle Δθ of the wavelength selection element 4 matching the center wavelength change Δλ of the LED light source 10 calculated in S22 is guided. That is, the control unit 22 calculates the drive amount of the wavelength selection element in accordance with the illuminance measured by the illuminance measurement unit.

Further, in S24, similar to S4 in Fig. 5, the control unit 22 provides information on the tilt angle Δθ of the wavelength selection element 4 calculated in S23 to the drive unit 23, and the drive unit 23 tilts the wavelength selection element 4 by the tilt angle Δθ. By tilting the wavelength selection element 4 by the tilt angle Δθ, the center wavelengths of the LED light source 10 the wavelength selection element 4 can be matched.

According to the flowchart of Fig. 9, the control unit 22 calculates the value related to the center wavelength of the solid-state light source in accordance with the illuminance measured by the illuminance measurement unit and calculates the drive amount of the wavelength selection element in accordance with the calculated center wavelength of the solid-state light source.

According to this flowchart, by constantly monitoring the illuminance change of the LED light source 10 using the illuminance meter 71 after lighting of the LED light source 10, the center wavelength of the LED light source 10 can always match the center wavelength of the wavelength selection element 4.

In the flowchart of Fig. 9, calculation is performed in two steps, such as calculation of the center wavelength change Δλ from the illuminance change ΔI of the LED light source 10 performed in S22, and calculation of the tilt angle θ of the wavelength selection element 4 from the center wavelength change Δλ performed in S23. However, since both the center wavelength change Δλ and the tilt angle θ of the wavelength selection element 4 are results of prior measurement, the tilt angle θ of the wavelength selection element 4 may be directly calculated from the illuminance change ΔI of the LED light source 10, and S22 and S23 may be combined.

In addition, in the flowchart of Fig. 9, the tilt angle Δθ is calculated from the illuminance change ΔI via the center wavelength change Δλ. However, a method may also be adopted in which an illuminance is acquired in S21 instead of an illuminance change, and a relationship between the acquired illuminance and the tilt angle of the wavelength selection element is measured in advance and stored in the control unit 22. That is, the tilt angle of the wavelength selection element 4 may be calculated on the basis of an absolute value instead of a change amount.

### [Article manufacturing method]

An article manufacturing method according to the embodiments of the disclosure is suitable for manufacturing articles, for example, semiconductor elements, flat panel displays, liquid crystal display elements, and MEMS. The manufacturing method includes a step of exposing a substrate coated with a photosensitive agent using the exposure apparatus 100 described above, and a step of developing the exposed photosensitive agent. In addition, using a pattern of the developed photosensitive agent as a mask, an etching step, an ion implantation step, or the like is performed on a substrate to form a circuit pattern on the substrate. By repeating these steps of exposure, development, etching, and the like, a circuit pattern constituted of a plurality of layers is formed on the substrate. In a subsequent step, dicing (processing) is performed on the substrate on which the circuit pattern is formed, and steps of mounting, bonding, and inspecting chips are performed. In addition, the manufacturing method may include other well-known steps (oxidation, film formation, vapor deposition, doping, planarization, resist stripping, and the like). The article manufacturing method according to Embodiment is advantageous in at least one of performance, quality, productivity, and manufacturing cost of articles as compared with those in the related art.

While the disclosure has been described with reference to embodiments, it is to be understood that the disclosure is not limited to the disclosed embodiments. The scope of the following claims is to be accorded the broadest interpretation so as to encompass all such modifications and equivalent structures and functions.

In addition, as a part or the whole of the control according to the embodiments, a computer program realizing the function of the embodiments described above may be supplied to the illumination device or the like through a network or various storage media. Then, a computer (or a CPU, an MPU, or the like) of the illumination device or the like may be configured to read and execute the program. In such a case, the program and the storage medium storing the program configure the disclosure.

In addition, the disclosure includes those realized using at least one processor or circuit configured to perform functions of the embodiments explained above. For example, a plurality of processors may be used for distribution processing to perform functions of the embodiments explained above.

This application claims the benefit of Japanese Patent Application No. 2025-053164, filed on March 27, 2025, which is hereby incorporated by reference herein in its entirety.

## Claims

1. An illumination device illuminating an irradiation target surface with light from a solid-state light source, the device comprising:
a wavelength selection element allowing light of some wavelengths among light from the solid-state light source to pass therethrough;
driving unit for driving the wavelength selection element,
detecting unit for detecting a value related to a center wavelength of the solid-state light source, and
control unit for performing control to drive the wavelength selection element such that the center wavelength of the solid-state light source matches the center wavelength of the wavelengths passing through the wavelength selection element on the basis of the detected value related to the center wavelength.

2. The illumination device according to claim 1,
wherein the driving unit tilts the wavelength selection element with respect to an optical axis of the light.

3. The illumination device according to claim 1 or 2,
wherein the detection unit measures wavelength characteristics of the solid-state light source.

4. The illumination device according to claim 3,
wherein in the control, a drive amount of the wavelength selection element is calculated in accordance with the center wavelength of the measured wavelength characteristics.

5. The illumination device according to claim 4,
wherein the control unit stores a correspondence relationship between the center wavelength of the wavelengths passing through the wavelength selection element and the drive amount of the wavelength selection element.

6. The illumination device according to any one of claims 1 to 5,
wherein the detection unit includes a temperature measurement unit for measuring a temperature of the solid-state light source.

7. The illumination device according to claim 6,
wherein the control unit calculates a drive amount of the wavelength selection element in accordance with the temperature measured by the temperature measurement unit.

8. The illumination device according to claim 7,
wherein the control unit calculates the value related to the center wavelength of the solid-state light source in accordance with the temperature measured by the temperature measurement unit, and the drive amount of the wavelength selection element in accordance with the calculated center wavelength of the solid-state light source.

9. The illumination device according to any one of claims 1 to 8,
wherein the detection unit includes a illuminance measurement unit for measuring an illuminance of the illumination.

10. The illumination device according to claim 9,
wherein the control unit calculates the drive amount of the wavelength selection element in accordance with illuminance measured by the illuminance measurement unit.

11. The illumination device according to claim 10,
wherein the control unit calculates the value related to the center wavelength of the solid-state light source in accordance with the illuminance measured by the illuminance measurement unit, and the drive amount of the wavelength selection element in accordance with the calculated center wavelength of the solid-state light source.

12. The illumination device according to any one of claims 9 to 11,
wherein the illuminance measurement unit measures the illuminance on the irradiation target surface.

13. An exposure apparatus exposing a substrate with a reticle therebetween, the device comprising:
the illumination device according to claim 1 illuminating the reticle disposed on an illumination target surface; and
a projection optical system projecting a pattern of the reticle on the substrate.

14. An article manufacturing method comprising:
a step of exposing a substrate using the exposure apparatus according to claim 13;
a step of developing the exposed substrate; and
a step of manufacturing an article from the developed substrate.
